# EUROPEAN PATENT APPLICATION

(11) **EP 3 273 370 A1**
(43) Date of publication of application: **24.01.2018**
(21) Application number: 17181031.0
(22) Date of filing: 12.07.2017
(51) Int. Cl.: G06F 17/50

(54) **STEAM PATH DESIGN SYSTEM, COMPUTER PROGRAM PRODUCT AND RELATED METHODS**

(30) Priority: 21.07.2016 US 201615215765
(71) Applicant: General Electric Company, Schenectady, NY 12345 (US)
(72) Inventor: KOZA, Kenneth Michael, Schenectady, NY New York 12345-6000 (US); GUO, Tao, Schenectady, NY New York 12345-6000 (US); WANG, Yu, Schenectady, NY New York 12345-6000 (US)
(74) Representative: Foster, Christopher Michael

(57) **Abstract**

Various embodiments include a system having: at least one computing device (312) configured to design a flow path in a steam turbine (100) by performing actions including: for each component (107) in a set of steam path components (307) in the steam turbine (100): calculate an aspect ratio or a radius ratio for the component (107); design a shape of the component (107) based upon the calculated aspect ratio or radius ratio; determine a seal (80) type for the component (107) based upon the calculated aspect ratio or radius ratio; and determine a size of a cavity (90) adjacent the component (107) based upon the calculated aspect ratio or radius ratio, the shape of the component (107) and the seal (80) type.

## Description

### FIELD OF THE INVENTION

The subject matter disclosed herein relates to turbomachines such as steam turbines. More particularly, the subject matter disclosed herein relates to approaches for designing a steam path in a steam turbine.

### BACKGROUND OF THE INVENTION

Steam turbines designs are continually refined in order to improve efficiency. Two significant reasons for efficiency loss in steam turbines (e.g., in particular, high-pressure (HP) and intermediate-pressure (IP) sections) are secondary flow (interference) loss and leakage loss. Conventional approaches to reduce these losses have focused on secondary flow loss and/or leakage loss on a piece (part) level, however, these part-based approaches have failed to effectively account for the overall losses that a system experiences.

### BRIEF DESCRIPTION OF THE INVENTION

Various embodiments include a system having: at least one computing device configured to design a flow path in a steam turbine by performing actions including: for each component in a set of steam path components in the steam turbine: calculate an aspect ratio or a radius ratio for the component; design a shape of the component based upon the calculated aspect ratio or radius ratio; determine a seal type for the component based upon the calculated aspect ratio or radius ratio; and determine a size of a cavity adjacent the component based upon the calculated aspect ratio or radius ratio, the shape of the component and the seal type.

A first aspect of the disclosure includes a system having: at least one computing device configured to design a flow path in a steam turbine by performing actions including: for each component in a set of steam path components in the steam turbine: calculate an aspect ratio or a radius ratio for the component; design a shape of the component based upon the calculated aspect ratio or radius ratio; determine a seal type for the component based upon the calculated aspect ratio or radius ratio; and determine a size of a cavity adjacent the component based upon the calculated aspect ratio or radius ratio, the shape of the component and the seal type.

A second aspect of the disclosure includes a computer program product having program code on a computer-readable storage medium, which when executed by at least one computing devices, causes the at least one computing device to design a flow path in a steam turbine by performing actions including: for each component in a set of steam path components in the steam turbine: calculate an aspect ratio or a radius ratio for the component; design a shape of the component based upon the calculated aspect ratio or radius ratio; determine a seal type for the component based upon the calculated aspect ratio or radius ratio; and determine a size of a cavity adjacent the component based upon the calculated aspect ratio or radius ratio, the shape of the component and the seal type.

A third aspect of the disclosure includes a computer-implemented method of designing a flow path in a steam turbine, the method including: for each component in a set of steam path components in the steam turbine: calculate an aspect ratio or a radius ratio for the component; design a shape of the component based upon the calculated aspect ratio or radius ratio; determine a seal type for the component based upon the calculated aspect ratio or radius ratio; and determine a size of a cavity adjacent the component based upon the calculated aspect ratio or radius ratio, the shape of the component and the seal type.

### BRIEF DESCRIPTION OF THE DRAWINGS

These and other features of this invention will be more readily understood from the following detailed description of the various aspects of the invention taken in conjunction with the accompanying drawings that depict various embodiments of the disclosure, in which:
FIG. 1 is a perspective partial cut-away illustration of an illustrative turbine.
FIG. 2 shows a schematic close-up perspective of the turbine of FIG. 1.
FIG. 3. shows a flow diagram illustrating a method performed according to various embodiments of the disclosure.
FIG. 4 shows a schematic perspective view of a turbomachine component according to various embodiments of the disclosure.
FIG. 5 shows an environment including a steam path design system according to various embodiments of the disclosure.

It is noted that the drawings of the invention are not necessarily to scale. The drawings are intended to depict only typical aspects of the invention, and therefore should not be considered as limiting the scope of the invention. In the drawings, like numbering represents like elements between the drawings.

### DETAILED DESCRIPTION OF THE INVENTION

As indicated above, the subject matter disclosed herein relates to steam turbines. More particularly, the subject matter disclosed herein relates to flow path design in steam turbines.

In the following description, reference is made to the accompanying drawings that form a part thereof, and in which is shown by way of illustration specific example embodiments in which the present teachings may be practiced. These embodiments are described in sufficient detail to enable those skilled in the art to practice the present teachings and it is to be understood that other embodiments may be utilized and that changes may be made without departing from the scope of the present teachings.

Various embodiments include approaches for designing a steam path in a steam turbine. In various embodiments, the design is based upon a calculated aspect ratio (AR) or radius ratio (RR) for a given component.

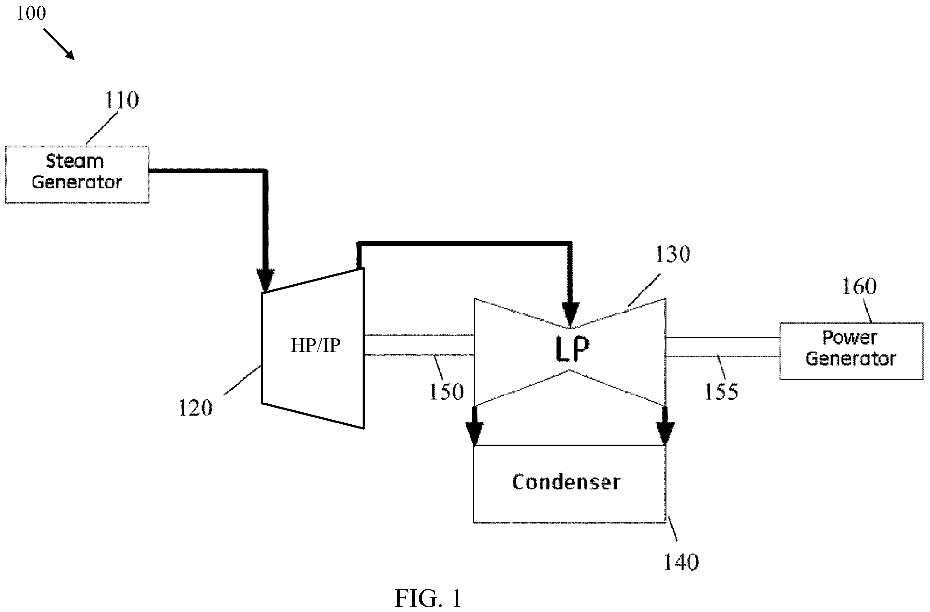

FIG. 1 shows a partial cross-sectional schematic view of a turbomachine system (or simply, turbomachine) 100 (e.g., a steam turbine) according to various embodiments. A steam generator 110 provides steam to a high pressure (HP)/intermediate pressure (IP) section 120 of steam turbine system 100. In some cases, as is known in the art, HP/IP section 120 can include a combined high-pressure/intermediate pressure (HP/IP) section. The various aspects of the disclosure are not limited to strictly high-pressure sections, and can apply equally to HP section, IP sections and/or combined HP/IP sections. The steam expands within HP/IP section 120 and exhaust from HP/IP section 120 and then passes to low pressure section 130. In low pressure section 130, steam again expands, exhausting to a condenser 140. During this operation, a first portion of a drive shaft 150 from HP/IP section 120 and a second portion of the drive shaft 155 from low pressure section 130 may provide shaft power to a power generator 160.

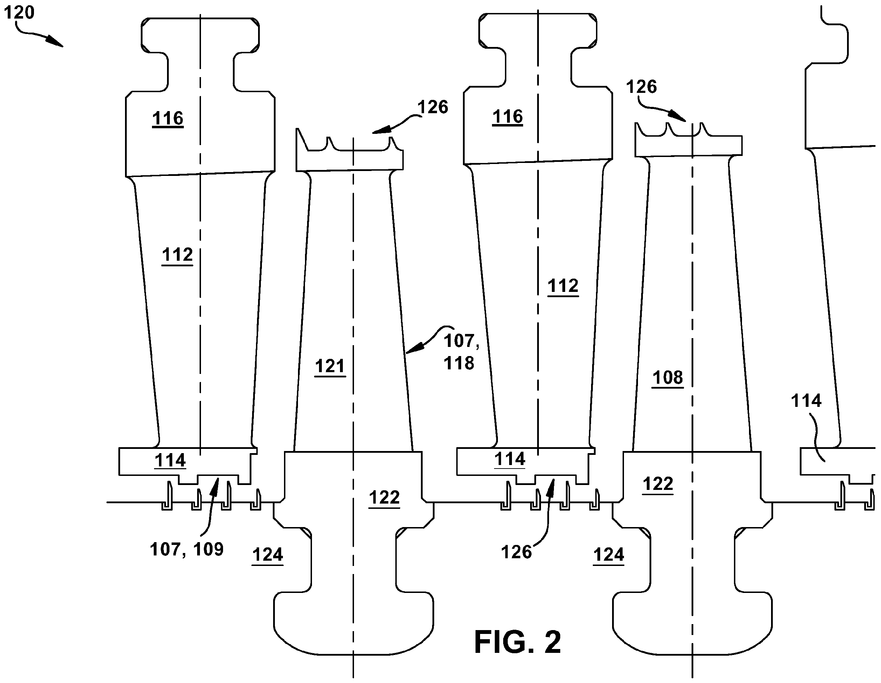

FIG. 2 shows a close-up cross-sectional illustration of a portion of the turbine section, e.g., HP section 120 of turbomachine system 100 of FIG. 1 according to various embodiments of the disclosure. A three-stage nozzle is shown in FIG. 2 merely for illustrative purposes, and it is understood that systems with any number of nozzle stages may benefit from the various teachings of the disclosure. As shown, HP/IP section 120 can include a turbomachine component 107, which can include a nozzle 109 in some cases. Nozzle 109 can include an airfoil (also called a vane) 112, a radially outer platform 114 coupled (e.g., welded, brazed, integrally cast, additively manufactured) to/with airfoil 112, and a radially inner platform 116 coupled (e.g., welded, brazed, integrally cast, additively manufactured) to/with airfoil 112. Platforms 112, 114 may help to retain nozzle 109 within turbine section 120 (HP/IP turbine). It is understood that according to various embodiments, that turbomachine component 107 can also include a turbomachine bucket 118, such as a dynamic steam turbomachine bucket. The bucket 118 can include a blade 121, a base 122 coupled to the blade 121 and a rotor body 124, and may include a shroud 126 for sealing adjacent stages of buckets 118 and nozzles 109. In some case, the turbomachine component 107 can include a portion of a bucket 118 or nozzle 109, such as a platform 112, 114, base 122, shroud 126, airfoil 112 and/or blade 121.

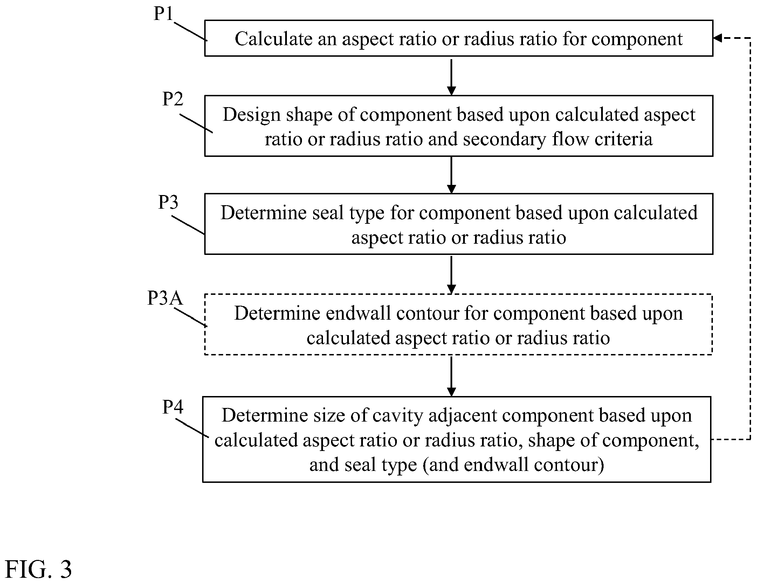

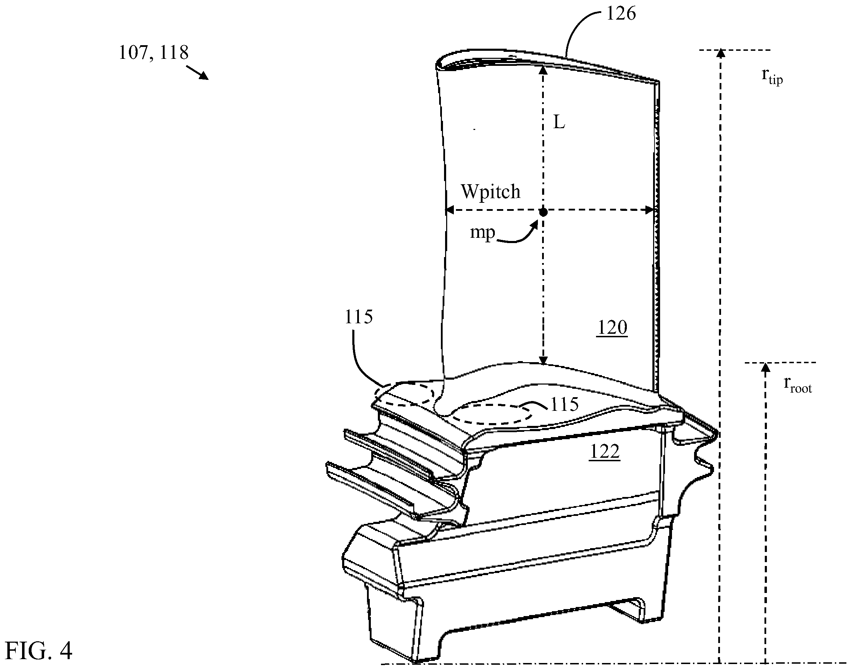

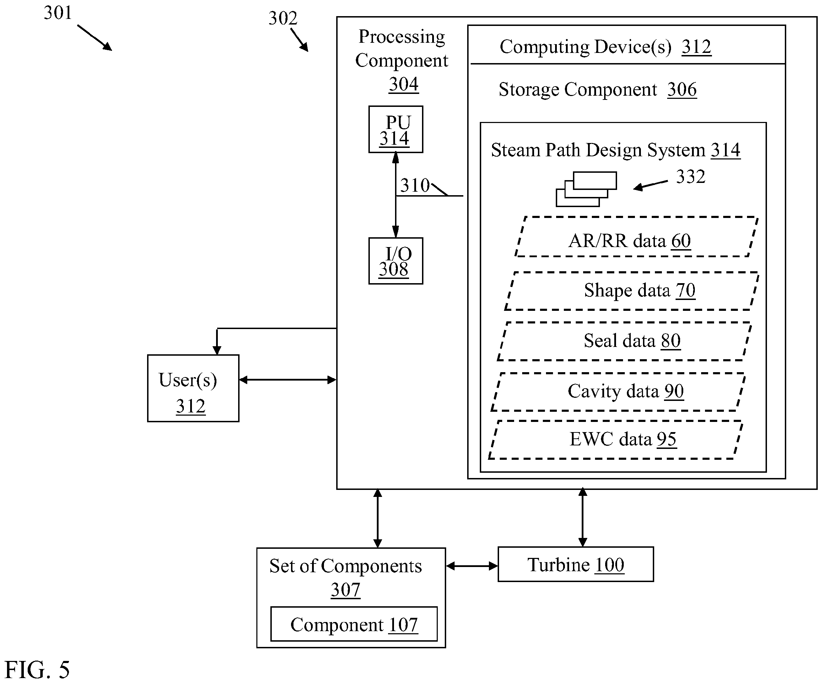

FIG. 3 shows a flow diagram illustrating processes according to various embodiments of the disclosure. These processes can be performed, for example, by a computing device 312 (FIG. 5), including steam path design system 314, which designs a steam flow path for a turbine, e.g., turbine 100. In other cases, these processes can be performed according to a computer-implemented method of designing a steam path. In still other embodiments, these processes can be performed by executing computer program code (e.g., steam path design system 314) to design a steam flow path (or simple, flow path) in a turbine (e.g., turbine 100). These processes are described with continuing reference to FIGS. 1-2. These processes can be performed for each component 107 (FIGS. 2, 4) in a set of components 307 (FIG. 5), and can include (for each component 107 in set of components 307, FIG. 5):

Process P1: Calculate an aspect ratio (AR) or a radius ratio (RR) for the component 107 (AR/RR data 60, FIG. 5). FIG. 4, referred to along with FIG. 3, shows a schematic depiction of a turbomachine component 107 (e.g., bucket 118), which illustrates AR and RR with respect to bucket 118. According to various embodiments, this process can include calculating an aspect ratio or radius ratio for a particular component 107, e.g., bucket 118 or nozzle 109, or a set (e.g., a row) of components 307. Aspect ratio, as used herein, refers to the ratio between the width (axial and/or chord) of component (nozzle or bucket) 107 at its midpoint (mp), and the total length (radial) of the same component 107 (AR = L/W_{pitch}). Radius ratio, as used herein, refers to the ratio of the tip radius of component 107 to the root radius of the same component 107 (RR =rₜᵢₚ/rᵣₒₒₜ). According to various embodiments, where component 107 includes bucket(s) 118 or nozzle(s) 109, AR or RR can be measured with respect to the airfoil within the bucket(s) 118 or nozzle(s) 109.

Process P2: Design a shape (shape data 70, FIG. 3) of component 107 based upon the calculated AR or RR. As noted herein, in various embodiments, component 107 can include at least one of a turbine bucket 118 or a turbine nozzle 109. In these cases, the shape of component 107 includes a shape of an airfoil in bucket 118 or nozzle109, or a shape of the endwalls (e.g., endwalls 114, 116 of nozzle 109, or base 122 or shroud 126 of bucket 118) of component 107. Various shapes (shape data 70) can include a free vortex shape (FV), a bow or lean shape (bow/lean) or an endwall shape. As described herein, secondary loss can be one of the major losses of loss in a turbine 100 (e.g., particularly in HP/IP turbine section 120). Secondary loss is caused by the vortex flows formed near endwalls 114, 116 or 122, 126 of nozzles 109 and buckets 118, respectively. As noted herein, the inventors have discovered that secondary loss can be effectively correlated with RR and AR (where RR generally represents nozzle/bucket 109/118 height, AR represents the slenderness of the nozzle/bucket 109/118. A nozzle 109 with a high RR or bucket 118 with a high AR (representing a longer or more slender blade), will generally have lower relative secondary losses. With this understanding, the inventors have determined that, for a given blade (nozzle/bucket 109/118), by calculating its RR/AR, component shapes can be designed to reduce secondary losses.

Process P3 (following process P1 in various embodiments, optionally following process P1 and P2 in some embodiments): Determine a seal type (seal data 80, FIG. 5) for component 107 based upon the calculated AR or RR. In various embodiments, the seal type may include at least one of a conventional Hi-Lo seal, a J-seal or a rotating brush seal. Seal type (selected from seal data 80) can correspond with a particular AR or RR, for example, a shorter blade (lower AR) may be better suited with a higher-performance (e.g., more expensive and/or complex) seal capable of reducing leakage flow around component 116 (e.g., bucket 121 or blade 112), while a taller blade (higher AR) may be better suited with a lower-performance (e.g., less expensive and/or complex) seal. This design approach according to various embodiments can provide an enhanced efficiency-to-cost ratio when compared with conventional design approaches.

Process P4 (following processes P1-P3 in various embodiments): Determine a size of a cavity (cavity data 90, FIG. 5) adjacent component 107 based upon the calculated AR or RR (AR/RR data 60), the shape of component 107 (shape data 70) and the seal type (seal data 80). In some cases, the size of the cavity is also based upon an acceptable amount of parasitic loss in turbine 100. Parasitic losses refer to the losses caused by the vortices formed within the cavities adjacent to the blades (nozzle/bucket 109/118). Generally speaking, larger cavities induce larger parasitic losses. The inventors have found that by linking cavity design (cavity data 90) with the RR/AR for a nozzle/bucket 109/118, the size and geometry of the cavity (cavity data 90) can be determined to reduce the parasitic loss.

In various embodiments, the above-noted process can include an additional intermediate step, shown as process P3A, which includes:

Determining an endwall contour 115 (EWC data 95) for component 107 based upon the calculated AR or RR (AR/RR data 60). An endwall contour (EWC) 115 is a contour (shape) of the inner endwall 116 (or base 122), and/or outer endwall 114 (or shroud 126) for components 107 (e.g., bucket 118 or blade 109) which may modify fluid flow characteristics in turbine 10 including such a component 107. Two locations of EWC 115 are illustrated schematically in FIG. 4 as examples of an EWC 115. An effectively designed endwall contour 115 (shape) can provide better guidance to the fluid flows near the endwalls (116, 114, 122, 126) of component 107 when compared with conventional endwalls. The shape of the EWC 115 can be based on the calculated RR/AR, as described herein. As noted herein, in some cases (e.g. high RR/AR cases), EWC 115 can be excluded from component 107 due to expected small efficiency benefits (based upon AR/RR data 60). In cases wherein an EWC 115 is selected, process P4 can further include determining the size of the cavity adjacent component 107 based upon the determined endwall contour 115 (EWC data 95) for component 107 (indicated in parenthesis in FIG. 3).

According to various embodiments, a plurality of components 107 can be designed, either simultaneously or sequentially, in order to create a steam flow path which reduces the secondary loss and/or parasitic loss in turbine 100, without incurring significant cost increases relative to conventional approaches. That is, according to various embodiments, components 107, such as multiple stages of buckets 118 and blades 107, can be designed in order to create a steam flow path through turbine 100.

It is understood that in the flow diagrams shown and described herein, other processes may be performed while not being shown, and the order of processes can be rearranged according to various embodiments. Additionally, intermediate processes may be performed between one or more described processes. The flow of processes shown and described herein is not to be construed as limiting of the various embodiments.

FIG. 5 shows an illustrative environment 301 including steam path design system 314, for performing the functions described herein according to various embodiments of the invention. To this extent, the environment 301 includes a computer system 302 that can perform one or more processes described herein in order to monitor and/or control turbine 100 (FIG. 1). In particular, the computer system 302 is shown as including the steam path design system 314, which makes computer system 302 operable to design a component 107 and/or a set of components 107 in a steam path by performing any/all of the processes described herein and implementing any/all of the embodiments described herein.

The computer system 302 is shown including computing device 312, which can include a processing component 304 (e.g., one or more processors), a storage component 306 (e.g., a storage hierarchy), an input/output (I/O) component 308 (e.g., one or more I/O interfaces and/or devices), and a communications pathway 310. In general, the processing component 304 executes program code, such as the steam path design system 314, which is at least partially fixed in the storage component 107. While executing program code, the processing component 304 can process data, which can result in reading and/or writing transformed data from/to the storage component 306 and/or the I/O component 308 for further processing. The pathway 310 provides a communications link between each of the components in the computer system 302. The I/O component 308 can comprise one or more human I/O devices, which enable a user (e.g., a human and/or computerized user) 312 to interact with the computer system 302 and/or one or more communications devices to enable the system user 312 to communicate with the computer system 302 using any type of communications link. To this extent, the steam path design system 314 can manage a set of interfaces (e.g., graphical user interface(s), application program interface, etc.) that enable human and/or system users 312 to interact with the steam path design system 314. Further, the steam path design system 314 can manage (e.g., store, retrieve, create, manipulate, organize, present, etc.) data, such as AR/RR data 60, shape data 70, seal data 80, cavity data 90 and/or EWC data 95 using any solution, e.g., via wireless and/or hardwired means.

In any event, the computer system 302 can comprise one or more general purpose computing articles of manufacture (e.g., computing devices) capable of executing program code, such as the steam path design system 314, installed thereon. As used herein, it is understood that "program code" means any collection of instructions, in any language, code or notation, that cause a computing device having an information processing capability to perform a particular function either directly or after any combination of the following: (a) conversion to another language, code or notation; (b) reproduction in a different material form; and/or (c) decompression. To this extent, the steam path design system 314 can be embodied as any combination of system software and/or application software. It is further understood that the steam path design system 314 can be implemented in a cloud-based computing environment, where one or more processes are performed at second computing devices (e.g., a plurality of computing devices 312), where one or more of those second computing devices may contain only some of the components shown and described with respect to the computing device 312 of FIG. 5.

Further, steam path design system 314 can be implemented using a set of modules 332. In this case, a module 332 can enable the computer system 302 to perform a set of tasks used by the steam path design system 314, and can be separately developed and/or implemented apart from other portions of the steam path design system 314. As used herein, the term "component" means any configuration of hardware, with or without software, which implements the functionality described in conjunction therewith using any solution, while the term "module" means program code that enables the computer system 302 to implement the functionality described in conjunction therewith using any solution. When fixed in a storage component 306 of a computer system 302 that includes a processing component 304, a module is a substantial portion of a component that implements the functionality. Regardless, it is understood that two or more components, modules, and/or systems may share some/all of their respective hardware and/or software. Further, it is understood that some of the functionality discussed herein may not be implemented or additional functionality may be included as part of the computer system 302.

When the computer system 302 comprises multiple computing devices, each computing device may have only a portion of steam path design system 314 fixed thereon (e.g., one or more modules 332). However, it is understood that the computer system 302 and steam path design system 314 are only representative of various possible equivalent computer systems that may perform a process described herein. To this extent, in other embodiments, the functionality provided by the computer system 302 and steam path design system 314 can be at least partially implemented by one or more computing devices that include any combination of general and/or specific purpose hardware with or without program code. In each embodiment, the hardware and program code, if included, can be created using standard engineering and programming techniques, respectively.

Regardless, when the computer system 302 includes multiple computing devices 312, the computing devices can communicate over any type of communications link. Further, while performing a process described herein, the computer system 302 can communicate with one or more other computer systems using any type of communications link. In either case, the communications link can comprise any combination of various types of wired and/or wireless links; comprise any combination of one or more types of networks; and/or utilize any combination of various types of transmission techniques and protocols.

While shown and described herein as a method and system for designing component(s) 107 within a turbomachine 100 (FIG. 1), it is understood that aspects of the invention further provide various alternative embodiments. For example, in one embodiment, the invention provides a computer program fixed in at least one computer-readable medium, which when executed, enables a computer system to design component(s) 107 within a turbomachine 100 (FIG. 1). To this extent, the computer-readable medium includes program code, such as the steam path design system 314 (FIG. 4), which implements some or all of the processes and/or embodiments described herein. It is understood that the term "computer-readable medium" comprises one or more of any type of tangible medium of expression, now known or later developed, from which a copy of the program code can be perceived, reproduced, or otherwise communicated by a computing device. For example, the computer-readable medium can comprise: one or more portable storage articles of manufacture; one or more memory/storage components of a computing device; paper; etc.

In another embodiment, the invention provides a method of providing a copy of program code, such as the steam path design system 314 (FIG. 5), which implements some or all of a process described herein. In this case, a computer system can process a copy of program code that implements some or all of a process described herein to generate and transmit, for reception at a second, distinct location, a set of data signals that has one or more of its characteristics set and/or changed in such a manner as to encode a copy of the program code in the set of data signals. Similarly, an embodiment of the invention provides a method of acquiring a copy of program code that implements some or all of a process described herein, which includes a computer system receiving the set of data signals described herein, and translating the set of data signals into a copy of the computer program fixed in at least one computer-readable medium. In either case, the set of data signals can be transmitted/received using any type of communications link.

In still another embodiment, the invention provides a method of designing a steam flow path (including, e.g., component(s) 107) within a turbomachine 100 (FIG. 1). In this case, a computer system, such as computer system 302 (FIG. 5), can be obtained (e.g., created, maintained, made available, etc.) and one or more components for performing a process described herein can be obtained (e.g., created, purchased, used, modified, etc.) and deployed to the computer system. To this extent, the deployment can comprise one or more of: (1) installing program code on a computing device; (2) adding one or more computing and/or I/O devices to the computer system; (3) incorporating and/or modifying the computer system to enable it to perform a process described herein; etc.

In any case, the technical effect of the various embodiments of the disclosure, including, e.g., steam path design system 314, is to design component(s) 107 within a steam path in turbomachine 100 (FIG. 1). It is understood that according to various embodiments, steam path design system 314 could be implemented to monitor a design component(s) 107 within a plurality of turbomachines (e.g., similar or dissimilar to turbine 100).

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

Various aspects and embodiments of the present invention are defined by the following clauses:
1. A system comprising:
   at least one computing device configured to design a flow path in a steam turbine by performing actions including:
      for each component in a set of steam path components in the steam turbine:
         calculate an aspect ratio or a radius ratio for the component;
         design a shape of the component based upon the calculated aspect ratio or radius ratio;
         determine a seal type for the component based upon the calculated aspect ratio or radius ratio; and
         determine a size of a cavity adjacent the component based upon the calculated aspect ratio or radius ratio, the shape of the component and the seal type.
2. The system of clause 1, wherein the at least one computing device is further configured to determine an endwall contour for the component based upon the calculated aspect ratio or radius ratio.
3. The system of clause 2, wherein the determining of the size of the cavity adjacent the component is further based upon the determined endwall contour for the component.
4. The system of clause 2, wherein the determining of the endwall contour for the component includes excluding endwall contouring from the component based upon the calculated aspect ratio or radius ratio.
5. The system of clause 1, wherein the component in the steam turbine includes at least one of a turbine bucket or a turbine nozzle.
6. The system of clause 5, wherein the shape of the component includes a shape of an airfoil in the turbine bucket or the turbine nozzle.
7. The system of clause 1, wherein the set of steam path components includes at least one set of nozzles and at least one set of buckets.
8. The system of clause 1, wherein the secondary flow criteria includes an acceptable amount of secondary flow proximate the component, and wherein the secondary flow criteria is based upon an output requirement of the turbine.
9. The system of clause 1, wherein the seal type includes at least one of a J-seal or a rotating brush seal.
10. The system of clause 1, wherein the size of the cavity is determined based upon an acceptable amount of parasitic loss in the turbine.
11. The system of clause 10, wherein the at least one computing device is further configured to determine an endwall contour for the component based upon the selected aspect ratio or radius ratio.
12. A computer program product comprising program code on a computer-readable storage medium, which when executed by at least one computing devices, causes the at least one computing device to design a flow path in a steam turbine by performing actions including:
   for each component in a set of steam path components in the steam turbine:
      calculate an aspect ratio or a radius ratio for the component;
      design a shape of the component based upon the calculated aspect ratio or radius ratio;
      determine a seal type for the component based upon the calculated aspect ratio or radius ratio; and
      determine a size of a cavity adjacent the component based upon the calculated aspect ratio or radius ratio, the shape of the component and the seal type.
13. The computer program product of clause 12, wherein the at least one computing device is further configured to determine an endwall contour for the component based upon the calculated aspect ratio or radius ratio.
14. The computer program product of clause 13, wherein the determining of the size of the cavity adjacent the component is further based upon the determined endwall contour for the component.
15. The computer program product of clause 12, wherein the component in the steam turbine includes at least one of a turbine bucket or a turbine nozzle, wherein the shape of the component includes a shape of an airfoil in the turbine bucket or the turbine nozzle.
16. The computer program product of clause 12, wherein the set of steam path components includes at least one set of nozzles and at least one set of buckets.
17. The computer program product of clause 12, wherein the secondary flow criteria includes an acceptable amount of secondary flow proximate the component, and wherein the secondary flow criteria is based upon an output requirement of the turbine.
18. The computer program product of clause 12, wherein the seal type includes at least one of a J-seal or a rotating brush seal.
19. The computer program product of clause 12, wherein the at least one computing device is further configured to determine an endwall contour for the component based upon the selected aspect ratio or radius ratio.
20. A computer-implemented method of designing a flow path in a steam turbine, the method comprising:
   for each component in a set of steam path components in the steam turbine:
      calculate an aspect ratio or a radius ratio for the component;
      design a shape of the component based upon the calculated aspect ratio or radius ratio;
      determine a seal type for the component based upon the calculated aspect ratio or radius ratio; and
      determine a size of a cavity adjacent the component based upon the calculated aspect ratio or radius ratio, the shape of the component and the seal type.

## Claims

1. A system comprising:
at least one computing device (312) configured to design a flow path in a steam turbine (100) by performing actions including:
for each component (107) in a set of steam path components (307) in the steam turbine (100):
calculate an aspect ratio or a radius ratio for the component (107);
design a shape of the component (107) based upon the calculated aspect ratio or radius ratio;
determine a seal (80) type for the component (107) based upon the calculated aspect ratio or radius ratio; and
determine a size of a cavity (90) adjacent the component (107) based upon the calculated aspect ratio or radius ratio, the shape of the component (107) and the seal (80) type.

2. The system of claim 1, wherein the at least one computing device (312) is further configured to determine an endwall contour (115) for the component (107) based upon the calculated aspect ratio or radius ratio.

3. The system of claim 1 or claim 2, wherein the determining of the size of the cavity (90) adjacent the component (107) is further based upon the determined endwall contour (115) for the component (107).

4. The system of claim 2, wherein the determining of the endwall contour (115) for the component (107) includes excluding endwall contouring (115) from the component (107) based upon the calculated aspect ratio or radius ratio.

5. The system of any preceding claim, wherein the component (107) in the steam turbine (100) includes at least one of a turbine bucket (118) or a turbine nozzle (109).

6. The system of claim 5, wherein the shape of the component (107) includes a shape of an airfoil (112) in the turbine bucket (118) or the turbine nozzle (109).

7. The system of any preceding claim, wherein the set of steam path components (307) includes at least one set of nozzles (109) and at least one set of buckets (118).

8. The system of claim 1, wherein the secondary flow criteria includes an acceptable amount of secondary flow proximate the component (107), and wherein the secondary flow criteria is based upon an output requirement of the turbine (100).

9. The system of any preceding claim, wherein the seal (80) type includes at least one of a J-seal or a rotating brush seal.

10. A computer-implemented method of designing a flow path in a steam turbine (100), the method comprising:
for each component (107) in a set of steam path components (307) in the steam turbine (100):
calculate an aspect ratio or a radius ratio for the component (107);
design a shape of the component (107) based upon the calculated aspect ratio or radius ratio;
determine a seal (80) type for the component based upon the calculated aspect ratio or radius ratio; and
determine a size of a cavity (90) adjacent the component (107) based upon the calculated aspect ratio or radius ratio, the shape of the component (107) and the seal (80) type.

11. A computer program product comprising program code on a computer-readable storage medium, which when executed by at least one computing devices (312), causes the at least one computing device (312) to design a flow path in a steam turbine (100) by performing actions including:
for each component (107) in a set of steam path components (307) in the steam turbine (100):
calculate an aspect ratio or a radius ratio for the component;
design a shape of the component based upon the calculated aspect ratio or radius ratio;
determine a seal (80) type for the component based upon the calculated aspect ratio or radius ratio; and
determine a size of a cavity (90) adjacent the component based upon the calculated aspect ratio or radius ratio, the shape of the component and the seal (80) type.

12. The computer program product of claim 11, wherein the at least one computing device (312) is further configured to determine an endwall contour (115) for the component based upon the calculated aspect ratio or radius ratio.

13. The computer program product of claim 11 or 12, wherein the component in the steam turbine (100) includes at least one of a turbine bucket (118) or a turbine nozzle (109), wherein the shape of the component includes a shape of an airfoil (112) in the turbine bucket (118) or the turbine nozzle (109).

14. The computer program product of any one of claims 11 to 13, wherein the set of steam path components (307) includes at least one set of nozzles (109) and at least one set of buckets (118).

15. The computer program product of claim 11, wherein the secondary flow criteria includes an acceptable amount of secondary flow proximate the component, and wherein the secondary flow criteria is based upon an output requirement of the turbine (100).
